(19) **Europäisches Patentamt European Patent Office Office européen des brevets**

(11) **EP 3 615 327 B1**

(12) **EUROPEAN PATENT SPECIFICATION**

(45) Date of publication and mention of the grant of the patent:
**24.03.2021 Bulletin 2021/12**

(21) Application number: **18723265.7**

(22) Date of filing: **23.04.2018**

(51) Int Cl.:
**B32B 7/02** *(2019.01)* **B32B 27/08** *(2006.01)*
**B32B 27/32** *(2006.01)*

(86) International application number:
**PCT/US2018/028827**

(87) International publication number:
**WO 2018/200366 (01.11.2018 Gazette 2018/44)**

(54) **MULTILAYER STRUCTURES, PROCESSES FOR MANUFACTURING MULTILAYER STRUCTURES, AND RELATED ARTICLES**

MEHRSCHICHTSTRUKTUREN, VERFAHREN ZUR HERSTELLUNG VON MEHRSCHICHTSTRUKTUREN UND VERWANDTE GEGENSTÄNDE

STRUCTURES MULTICOUCHES, PROCÉDÉS DE FABRICATION DE STRUCTURES MULTICOUCHES ET ARTICLES ASSOCIÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.04.2017 PCT/CN2017/081590**

(43) Date of publication of application:
**04.03.2020 Bulletin 2020/10**

(73) Proprietor: **Dow Global Technologies LLC Midland, MI 48674 (US)**

(72) Inventors:
- **WANG, Gang Shanghai 201203 (CN)**
- **XU, Jingyi Shanghai 201203 (CN)**
- **PAN, Jianping Shanghai 201203 (CN)**
- **YUN, Xiaobing Shanghai 201203 (CN)**

(74) Representative: **Boult Wade Tennant LLP Salisbury Square House 8 Salisbury Square London EC4Y 8AP (GB)**

(56) References cited:
**WO-A1-00/40407 WO-A1-2015/154253 WO-A1-2017/000339 WO-A1-2017/087809 WO-A1-2017/120340 WO-A1-2018/048580 US-A- 5 006 378**

**Description**

**Field**

The present invention relates to multilayer structures, to articles comprising such multilayer structures, and to processes for manufacturing multilayer structures.

**Introduction**

Some packages such as food packages are designed to protect the contents from the external environment and to facilitate a longer shelf. Such packages are often constructed using barrier films with low oxygen transmission rates (OTR) and water vapor transmission rates (WVTR). However, in balancing the barrier properties, consideration is also given to package integrity to, for example, avoid leakage.

To make barrier films, a typical approach is to plate metal layer on polymeric substrate films through vacuum metallization process. A thin coating of metal, often aluminum, can be used to provide barrier properties to polymeric films which may on their own lack resistance to the permeation of vapors and/or gases. In order to make such substrate film and gain a high quality metallized product, the substrate should have high stiffness, dimensional stability under tension, and a smooth surface for stable production and a glossy appearance. Typical metalized substrates include polypropylene (PP), biaxially oriented polypropylene (BOPP), and polyethylene terephthalate (PET). Polyethylene films are not widely used as substrates for metallization due to their inferior dimensional stability under tension especially in high-speed vacuum metallization processes. Moreover, the less glossy metallized surfaces of polyethylene films negatively influence the visual appearance of packaging. However, even with vacuum metalized PET (VMPET) films and vacuum metalized PP (VMPP) films, problems still exist. For example, VMPET is not sealable at desirable temperatures and thus needs to be laminated to an extra sealant layer requires additional production steps and brings a higher cost. While VMPP is a better choice than VMPET, its relatively high heat sealing initial temperature (HSIT) limits the packaging speed. WO0040407 discloses a biaxially oriented multi-layer film.

There remains a need for new approaches to multilayer structures that provide barrier properties, desirable package integrity, and favorable sealing conditions.

**Summary**

The present invention provides multilayer films that can provide a good synergy of barrier properties and mechanical properties. For example, in some embodiments, multilayer structures of the present invention can provide a good barrier to oxygen and/or water vapor while exhibiting desirable stiffness, toughness, and/or optical properties. Multilayer structures of the present invention, in some embodiments, can also exhibit low temperature sealing performance that can off advantages over existing VMPET/polyethylene laminates and/or high temperature sealable VMPP films.

In one aspect, the present invention provides a multilayer structure that comprises (a) a biaxially oriented polyethylene film comprising an outer layer that comprises a first polyethylene composition comprising at least two linear low density polyethylenes, wherein the first polyethylene composition has a density of 0.910 to 0.940 g/cm$^3$, an $MW_{HDF>95}$ greater than 135 kg/mol and an $I_{HDF>95}$ greater than 42 kg/mol, wherein the film has a thickness of 10 to 60 microns after orientation, and (b) a metal layer comprising a metal deposited on the outer layer, wherein the metal comprises Al, Zn, Au, Ag, Cu, Ni, Cr, Ge, Se, Ti, Sn, or oxides thereof, and wherein the multilayer structure has an optical density of 1.0 to 3.6, wherein the multilayer structure has a 2% secant modulus of at least 300 MPa in the machine direction when measured according to ASTM D882, and wherein the multilayer structure has an oxygen gas transmission rate of 350 cc/[m$^2$-day] or less when measured according to ASTM D3985-05.

In another aspect, the present invention relates to an article, such as a food package, comprising any of the multilayer structures disclosed herein.

In another aspect, the present invention relates to a process for manufacturing a multilayer structure wherein the process comprises (a) forming a polyethylene film having an outer layer that comprises a first polyethylene composition comprising at least two linear low density polyethylenes, wherein the first polyethylene composition has a density of 0.910 to 0.940 g/cm$^3$, an $MW_{HDF>95}$ greater than 135 kg/mol and an $I_{HDF>95}$ greater than 42 kg/mol; (b) biaxially orienting the polyethylene film from step (a) by orienting the film in the machine direction at a draw ratio from 2:1 to 6:1 and in the cross direction at a draw ratio from 2:1 to 9:1, wherein the oriented polyethylene film has a thickness of 10 to 60 microns after orientation; and (c) vacuum depositing a metal layer on the outer layer of the polyethylene film, wherein the metal comprises Al, Zn, Au, Ag, Cu, Ni, Cr, Ge, Se, Ti, Sn, or oxides thereof, and wherein the multilayer structure has an optical density of 1.0 to 3.6.

These and other embodiments are described in more detail in the Detailed Description.

**Detailed Description**

Unless stated to the contrary, implicit from the context, or customary in the art, all parts and percents are based on weight, all temperatures are in ° C, and all test methods are current as of the filing date of this disclosure.

The term "composition," as used herein, refers to a mixture of materials which comprises the composition, as well as reaction products and decomposition products formed from the materials of the composition.

"Polymer" means a polymeric compound prepared by polymerizing monomers, whether of the same or a different type. The generic term polymer thus embraces the term homopolymer (employed to refer to polymers prepared from only one type of monomer, with the understanding that trace amounts of impurities can be incorporated into the polymer structure), and the term interpolymer as defined hereinafter. Trace amounts of impurities (for example, catalyst residues) may be incorporated into and/or within the polymer. A polymer may be a single polymer, a polymer blend or polymer mixture.

The term "interpolymer," as used herein, refers to polymers prepared by the polymerization of at least two different types of monomers. The generic term interpolymer thus includes copolymers (employed to refer to polymers prepared from two different types of monomers), and polymers prepared from more than two different types of monomers.

The terms "olefin-based polymer" or "polyolefin", as used herein, refer to a polymer that comprises, in polymerized form, a majority amount of olefin monomer, for example ethylene or propylene (based on the weight of the polymer), and optionally may comprise one or more comonomers.

"Polypropylene" means a polymer having greater than 50 wt% units derived from propylene monomer. The term "polypropylene" includes homopolymers of propylene such as isotactic polypropylene, random copolymers of propylene and one or more $C_{2,4-8}$ $\alpha$-olefins in which propylene comprises at least 50 mole percent, and impact copolymers of polypropylene.

The term, "ethylene/$\alpha$-olefin interpolymer," as used herein, refers to an interpolymer that comprises, in polymerized form, a majority amount of ethylene monomer (based on the weight of the interpolymer), and an $\alpha$-olefin.

The term, "ethylene/$\alpha$-olefin copolymer," as used herein, refers to a copolymer that comprises, in polymerized form, a majority amount of ethylene monomer (based on the weight of the copolymer), and an $\alpha$-olefin, as the only two monomer types.

The term "in adhering contact" and like terms mean that one facial surface of one layer and one facial surface of another layer are in touching and binding contact to one another such that one layer cannot be removed from the other layer without damage to the interlayer surfaces (i.e., the in-contact facial surfaces) of both layers.

The terms "comprising," "including," "having," and their derivatives, are not intended to exclude the presence of any additional component, step or procedure, whether or not the same is specifically disclosed. In order to avoid any doubt, all compositions claimed through use of the term "comprising" may include any additional additive, adjuvant, or compound, whether polymeric or otherwise, unless stated to the contrary. In contrast, the term, "consisting essentially of" excludes from the scope of any succeeding recitation any other component, step or procedure, excepting those that are not essential to operability. The term "consisting of" excludes any component, step or procedure not specifically delineated or listed.

"Polyethylene" or "ethylene-based polymer" shall mean polymers comprising greater than 50% by weight of units which have been derived from ethylene monomer. This includes polyethylene homopolymers or copolymers (meaning units derived from two or more comonomers). Common forms of polyethylene known in the art include Low Density Polyethylene (LDPE); Linear Low Density Polyethylene (LLDPE); Ultra Low Density Polyethylene (ULDPE); Very Low Density Polyethylene (VLDPE); single-site catalyzed Linear Low Density Polyethylene, including both linear and substantially linear low density resins (m-LLDPE); Medium Density Polyethylene (MDPE); and High Density Polyethylene (HDPE). These polyethylene materials are generally known in the art; however, the following descriptions may be helpful in understanding the differences between some of these different polyethylene resins.

The term "LDPE" may also be referred to as "high pressure ethylene polymer" or "highly branched polyethylene" and is defined to mean that the polymer is partly or entirely homopolymerized or copolymerized in autoclave or tubular reactors at pressures above 14,500 psi (100 MPa) with the use of free-radical initiators, such as peroxides (see for example US 4,599,392, which is hereby incorporated by reference). LDPE resins typically have a density in the range of 0.916 to 0.935 g/cm$^3$.

The term "LLDPE", includes both resin made using the traditional Ziegler-Natta catalyst systems as well as single-site catalysts, including, but not limited to, bis-metallocene catalysts (sometimes referred to as "m-LLDPE") and constrained geometry catalysts, and includes linear, substantially linear or heterogeneous polyethylene copolymers or homopolymers. LLDPEs contain less long chain branching than LDPEs and include the substantially linear ethylene polymers which are further defined in U.S. Patent 5,272,236, U.S. Patent 5,278,272, U.S. Patent 5,582,923 and US Patent 5,733,155; the homogeneously branched linear ethylene polymer compositions such as those in U.S. Patent No. 3,645,992; the heterogeneously branched ethylene polymers such as those prepared according to the process disclosed in U.S. Patent No. 4,076,698; and/or blends thereof (such as those disclosed in US 3,914,342 or US 5,854,045). The LLDPEs can be made via gas-phase, solution-phase or slurry polymerization or any combination thereof, using any type of reactor or reactor configuration known in the art.

The term "MDPE" refers to polyethylenes having densities from 0.926 to 0.935 g/cm$^3$. "MDPE" is typically made using chromium or Ziegler-Natta catalysts or using single-site catalysts including, but not limited to, bis-metallocene catalysts and constrained geometry catalysts, and typically have a molecular weight distribution ("MWD") greater than 2.5.

The term "HDPE" refers to polyethylenes having densities greater than about 0.935 g/cm$^3$, which are generally prepared with Ziegler-Natta catalysts, chrome catalysts or single-site catalysts including, but not limited to, bis-metallocene catalysts and constrained geometry catalysts.

The term "ULDPE" refers to polyethylenes having densities of 0.880 to 0.912 g/cm$^3$, which are generally prepared with Ziegler-Natta catalysts, chrome catalysts, or single-site catalysts including, but not limited to, bis-metallocene catalysts and constrained geometry catalysts.

All references to "MW$_{HDF>95}$" and "I$_{HDF>95}$" herein refer to these properties as measured according to Crystallization Elution Fractionation (CEF) as described in the TEST METHODS section below.

In one aspect, the present invention provides a multilayer structure that comprises (a) a biaxially oriented polyethylene film comprising an outer layer that comprises a first polyethylene composition comprising at least two linear low density polyethylenes, wherein the first polyethylene composition has a density of 0.910 to 0.940 g/cm$^3$, an MW$_{HDF>95}$ greater than 135 kg/mol and an I$_{HDF>95}$ greater than 42 kg/mol, wherein the film has a thickness of 10 to 60 microns after orientation; and (b) a metal layer comprising a metal deposited on the outer layer, wherein the metal comprises Al, Zn, Au, Ag, Cu, Ni, Cr, Ge, Se, Ti, Sn, or oxides thereof, and wherein the multilayer structure has an optical density of 1.0 to 3.6, wherein the multilayer structure has a 2% secant modulus of at least 300 MPa in the machine direction when measured according to ASTM D882, and wherein the multilayer structure has an oxygen gas transmission rate of 350 cc/[m$^2$-day] or less when measured according to ASTM D3985-05. The biaxially oriented polyethylene film has a thickness of 20 to 50 microns in some embodiments. In some embodiments, the multilayer structure has an optical density of 1.0 to 3.6.

In some embodiments, the biaxially oriented polyethylene film is oriented in the machine direction at a draw ratio from 2:1 to 6:1 and in the cross direction at a draw ratio from 2:1 to 9:1. The biaxially oriented polyethylene film, in some embodiments, is oriented in the machine direction at a draw ratio from 3:1 to 5:1 and in the cross direction at a draw ratio from 3:1 to 8:1. In some embodiments, the polyethylene film has an overall draw ratio (draw ratio in machine direction X draw ratio in cross direction) of 8 to 54. The polyethylene film, in some embodiments, has an overall draw ratio (draw ratio in machine direction X draw ratio in cross direction) of 9 to 40. In some embodiments, the ratio of the draw ratio in the machine direction to the draw ratio in the cross direction is from 1:1 to 1:2.5. The ratio of the draw ratio in the machine direction to the draw ratio in the cross direction is from 1:1.5 to 1:2.0 in some embodiments.

In some embodiments, the outer layer of the biaxially oriented polyethylene film comprises at least 50 weight percent of the first polyethylene composition based on the weight of the outer layer, and further comprises at least one of a high density polyethylene, a low density polyethylene, an ultra low density polyethylene, a polyethylene plastomer, a polyethylene elastomer, an ethylene vinyl acetate copolymer, an ethylene ethyl acrylate copolymer and any polymer comprising at least 50% ethylene monomer.

In some embodiments, the biaxially oriented polyethylene film is a monolayer film such that the outer layer is the only layer. The biaxially oriented polyethylene film, in some embodiments, is a multilayer film. In some such embodiments, the biaxially oriented polyethylene film further comprises a sealant layer.

In some embodiments, the metal is deposited on the outer layer by vacuum metallization.

In some embodiments, the multilayer structure has a dart impact of at least 10 grams/micron when measured according to ASTM D1709 (Method A).

A multilayer structure of the present invention can comprise a combination of two or more embodiments as described herein.

Embodiments of the present invention also relate to articles such as packages. In some embodiments, an article of the present invention can include any of the multilayer structures disclosed herein. An article of the present invention can comprise a combination of two or more embodiments as described herein.

Embodiments of the present invention also relate to processes for manufacturing multilayer structures. In one aspect, a process for manufacturing a multilayer structure comprises (a) forming a polyethylene film having an outer layer that comprises a first polyethylene composition comprising at least two linear low density polyethylenes, wherein the first polyethylene composition has a density of 0.910 to 0.940 g/cm$^3$, an MW$_{HDF>95}$ greater than 135 kg/mol and an I$_{HDF>95}$ greater than 42 kg/mol; (b) biaxially orienting the polyethylene film from step (a) by orienting the film in the machine direction at a draw ratio from 2:1 to 6:1 and in the cross direction at a draw ratio from 2:1 to 9:1, wherein the oriented polyethylene film has a thickness of 10 to 60 microns after orientation; and (c) vacuum depositing a metal layer on the outer layer of the polyethylene film, wherein the metal comprises Al, Zn, Au, Ag, Cu, Ni, Cr, Ge, Se, Ti, Sn, or oxides thereof, and wherein the multilayer structure has an optical density of 1.0 to 3.6. In some embodiments, the draw ratio in the machine direction is 3:1 to 5:1 and the draw ratio in the cross direction is 3:1 to 8:1. In some embodiments, the ratio of the draw ratio in the machine direction to the draw ratio in the cross direction is from 1:1 to 1:2.5.

A process of the present invention can comprise a combination of two or more embodiments as described herein.

Biaxially Oriented Polyethylene Film

Multilayer structures of the present invention comprise a biaxially oriented polyethylene film. The combination of the biaxially oriented polyethylene film with the metal layer (discussed below), in some embodiments, advantageously provides a synergistic combination of good barrier properties and good mechanical properties.

The biaxially oriented polyethylene film comprises an outer layer that comprises a first polyethylene composition that comprises at least two linear low density polyethylenes (LLDPE). It should be noted that when the film is a monolayer film, the outer layer would be the only layer. The LLDPEs used in the first polyethylene composition can include Ziegler-Natta catalyzed linear low density polyethylene, single site catalyzed (including metallocene) linear low density polyethylene, and medium density polyethylene (MDPE) so long as the MDPE has a density no greater than 0.940 g/cm$^3$, as well as combinations of two or more of the foregoing. The first polyethylene composition used in the outer layer can be characterized as having an $MW_{HDF>95}$ greater than 135 kg/mol and $I_{HDF>95}$ greater than 42 kg/mol.

The first polyethylene composition comprises from 20 to 50 wt% of a first linear low density polyethylene. All individual values and subranges from 20 to 50 percent by weight (wt%) are included herein and disclosed herein; for example the amount of the first linear low density polyethylene can be from a lower limit of 20, 30, or 40 wt% to an upper limit of 25, 35, 45, or 50 wt%. For example, the amount of the first linear low density polyethylene can be from 20 to 50 wt%, or in the alternative, from 20 to 35 wt%, or in the alternative, from 35 to 50 wt%, or in the alternative from 25 to 45wt%.

The first linear low density polyethylene has a density greater than or equal to 0.925 g/cm$^3$. All individual values and subranges greater than or equal to 0.925 g/cm$^3$ are included herein and disclosed herein; for example, the density of the first linear low density polyethylene can be from a lower limit of 0.925, 0.928, 0.931 or 0.934 g/cm$^3$. In some aspects, the first linear low density polyethylene has a density less than or equal to 0.980 g/cm$^3$. All individual values and subranges of less than 0.980 g/cm$^3$ are included herein and disclosed herein; for example, the first linear low density polyethylene can have a density from an upper limit of 0.975, 0.970, 0.960, 0.950, or 0.940 g/cm$^3$. In some embodiments, the first linear low density polyethylene has a density from 0.925 to 0.940 g/cm$^3$.

The first linear low density polyethylene has a melt index ($I_2$) less than or equal to 2 g/10 minutes. All individual values and subranges from 2 g/10 minutes are included herein and disclosed herein. For example, the first linear low density polyethylene can have an $I_2$ from an upper limit of 2, 1.9, 1.8, 1.7, 1.6 or 1.5 g/10 minutes. In a particular aspect, the first linear low density polyethylene has an $I_2$ with a lower limit of 0.01 g/10 minutes. All individual values and subranges from 0.01 g/10 minutes are included herein and disclosed herein. For example, the first linear low density polyethylene can have an $I_2$ greater than or equal to 0.01, 0.05, 0.1, 0.15 g/10 minutes.

The first polyethylene composition comprises from 80 to 50 wt% of a second linear low density polyethylene. All individual values and subranges from 80 to 50 wt% are included herein and disclosed herein; for example, the amount of the second linear low density polyethylene can be from a lower limit of 50, 60 or 70 wt% to an upper limit of 55, 65, 75 or 80 wt%. For example, the amount of the second linear low density polyethylene can be from 80 to 50 wt%, or in the alternative, from 80 to 60 wt%, or in the alternative, from 70 to 50 wt% , or in the alternative, from 75 to 60 wt%.

The second linear low density polyethylene has a density lower than or equal to 0.925 g/cc. All individual values and subranges lower than or equal to 0.925 g/cc are included herein and disclosed herein; for example, the density of the second linear low density polyethylene can have an upper limit of 0.925, 0.921, 0.918, 0.915, 0.911, or 0.905 g/cc. In a particular aspect, the density of the second linear low density polyethylene can have a lower limit of 0.865 g/cc. All individual values and subranges equal to or greater than 0.865 g/cc are included herein and disclosed herein; for example, the density of the second linear low density polyethylene can have a lower limit of 0.865, 0.868, 0.872, or 0.875 g/cc.

The second linear low density polyethylene has a melt index ($I_2$) greater than or equal to 2 g/10 minutes. All individual values and subranges from 2 g/10 minutes are included herein and disclosed herein; for example, the $I_2$ of the second linear low density polyethylene can have a lower limit of 2, 2.5, 5, 7.5 or 10 g/10 minutes. In a particular aspect, the second linear low density polyethylene has an $I_2$ of less than or equal to 1000 g/10 minutes.

In some embodiments, the first polyethylene composition (comprising the first linear low density polyethylene and the second linear low density polyethylene) used in the outer layer of the biaxially oriented polyethylene film has a density of 0.910 to 0.940 g/cm$^3$ in some embodiments. All individual values and subranges from 0.910 to 0.940 g/cm$^3$ are included herein and disclosed herein; for example, the density of the first polyethylene composition can be from a lower limit of 0.910, 0.915, 0.920, 0.922, 0.925, 0.928, or 0.930 g/cm$^3$ to an upper limit of 0.940, 0.935, 0.930, 0.925, 0.920 or 0.915 g/cm$^3$. In some aspects of the invention, the first polyethylene composition has a density from 0.910 to 0.930 g/cm$^3$. In some aspects of the invention, the first polyethylene composition has a density from 0.915 to 0.930 g/cm$^3$.

In some embodiments, the first polyethylene composition in the outer layer of the biaxially oriented polyethylene film has a melt index ($I_2$) of 30 g/10 minutes or less. All individual values and subranges up to 30 g/10 minutes are included herein and disclosed herein. For example, the first polyethylene composition can have a melt index from a lower limit of 0.1, 0.2, 0.25, 0.5, 0.75, 1, 2, 4, 5, 10, 15, 17, 20, 22, or 25 g/10 minutes to an upper limit of 2, 4, 5, 10, 15, 18, 20, 23, 25, 27, or 30 g/10 minutes. The first polyethylene composition, in some embodiments, has a melt index ($I_2$) of 2 to 15 g/10 minutes.

In some embodiments, the outer layer of the biaxially oriented polyethylene film comprises a significant amount of the first polyethylene composition. In some embodiments, the outer layer comprises at least 50 weight percent of the first polyethylene composition, based on the weight of the outer layer. The outer layer of the biaxially oriented polyethylene film comprises at least 70 weight percent of the first polyethylene composition, based on the weight of outer layer, in some embodiments. In some embodiments, the outer layer comprises at least 90 weight percent of the first polyethylene composition, based on the weight of outer layer. In some embodiments, the outer layer comprises at least 95 weight percent of the first polyethylene composition, based on the weight of the outer layer. The outer layer comprises up to 100 weight percent of the first polyethylene composition, based on the weight of the outer layer in some embodiments.

In embodiments where the linear low density polyethylenes in the first polyethylene composition are not the only polymers in the outer layer of the biaxially oriented polyethylene film, the outer layer comprises at least 50 weight percent of the first polyethylene composition, based on the weight of the outer layer, and the outer layer can further comprise other polymers that have, in polymerized form, a majority amount of ethylene (based on the weight of the polymer), and optionally may comprise one or more comonomers. Such polymers include high density polyethylene (HDPE), low density polyethylene (LDPE), ultra low density polyethylene (ULDPE), polyethylene plastomer, polyethylene elastomer, ethylene vinyl acetate copolymer, ethylene ethyl acrylate copolymer, any other polymer comprising at least 50% ethylene monomer, and combinations thereof. Persons of skill in the art can select suitable commercially available ethylene-based polymer for use in the outer layer based on the teachings herein.

The outer layer of the biaxially oriented polyethylene film may contain one or more additives as is generally known in the art. Such additives include antioxidants, such as IRGANOX 1010 and IRGAFOS 168 (commercially available from BASF), ultraviolet light absorbers, antistatic agents, pigments, dyes, nucleating agents, fillers, slip agents, fire retardants, plasticizers, processing aids, lubricants, stabilizers, smoke inhibitors, viscosity control agents, surface modification agents, and anti-blocking agents. The outer layer composition may advantageously, for example, comprise less than 10 percent by the combined weight of one or more additives, based on the weight of the outer layer in some embodiments, and less than 5 percent by weight in other embodiments.

In some embodiments, the biaxially oriented polyethylene film is a monolayer film such that the outer layer is the only layer.

In some embodiments, the biaxially oriented polyethylene film is a multilayer film. For example, a multilayer film can further comprise other layers typically included in multilayer films depending on the application including, for example, sealant layers, barrier layers, tie layers, other polyethylene layers.

As one example, in some embodiments, a multilayer film can comprise another layer (Layer B, with Layer A being the previously discussed outer layer) having a top facial surface and a bottom facial surface, wherein the top facial surface of Layer B is in adhering contact with a bottom facial surface of Layer A.

In some such embodiments, Layer B can be a sealant layer formed from one or more ethylene-based polymers as known to those of skill in the art to be suitable for use in a sealant layer.

However, as noted above, Layer B can comprise any number of other polymers or polymer blends. For example, if the multilayer films includes a barrier layer, Layer B could be a tie layer in adhering contact between the outer layer and the barrier layer, and another tie layer could be between the barrier layer and a sealant layer.

Depending on the composition of the additional layer and the multilayer film, in some embodiments, the additional layer can be coextruded with other layers in the film.

It should be understood that any of the foregoing layers can further comprise one or more additives as known to those of skill in the art such as, for example, antioxidants, ultraviolet light stabilizers, thermal stabilizers, slip agents, antiblock, pigments or colorants, processing aids, crosslinking catalysts, flame retardants, fillers and foaming agents.

Such polyethylene films (whether monolayer or multilayer), prior to biaxial orientation, can have a variety of thicknesses depending, for example, on the number of layers, the intended use of the film, and other factors. Such polyethylene films, in some embodiments, have a thickness prior to biaxial orientation of 320 to 3200 microns (typically, 640-1920 microns).

Prior to biaxial orientation, the polyethylene films can be formed using techniques known to those of skill in the art based on the teachings herein. For example, the films can be prepared as blown films (e.g., water quenched blown films) or cast films. For example, in the case of multilayer polyethylene films, for those layers that can be coextruded, such layers can be coextruded as blown films or cast films using techniques known to those of skill in the art based on the teachings herein.

In some embodiments, the polyethylene film is biaxially oriented using a tenter frame sequential biaxial orientation process. Such techniques are generally known to those of skill in the art. In other embodiments, the polyethylene film can be biaxially oriented using other techniques known to those of skill in the art based on the teachings herein, such as double bubble orientation processes. In general, with a tenter frame sequential biaxial orientation process, the tenter frame is incorporated as part of a multilayer co-extrusion line. After extruding from a flat die, the film is cooled down on a chill roll, and is immersed into a water bath filled with room temperature water. The cast film is then passed onto a series of rollers with different revolving speeds to achieve stretching in the machine direction. There are several pairs of rollers in the MD stretching segment of the fabrication line, and are all oil heated. The paired rollers work sequentially as pre-heated rollers, stretching rollers, and rollers for relaxing and annealing. The temperature of each pair of rollers is separately controlled. After stretching in the machine direction, the film web is passed into a tenter frame hot air oven with heating zones to carry out stretching in the cross direction. The first several zones are for pre-heating, followed by zones for stretching, and then the last zones for annealing.

Without wishing to be bound by any particular theory, it is believed that the biaxial orientation of the polyethylene film specified herein provides increased modulus and high ultimate strength which facilitates deposition of the metal layer (at high speeds, in some embodiments) and provides an improved glossy appearance.

In some embodiments, the polyethylene film can be oriented in the machine direction at a draw ratio of 2:1 to 6:1, or in the alternative, at a draw ratio of 3:1 to 5:1. The polyethylene film, in some embodiments, can be oriented in the cross direction at a draw ratio of 2:1 to 9:1, or in the alternative, at a draw ratio of 3:1 to 8:1. In some embodiments, the polyethylene film is oriented in the machine direction at a draw ratio of 2:1 to 6:1 and in the cross direction at a draw ratio of 2:1 to 9:1. The polyethylene film, in some embodiments, is oriented in the machine direction at a draw ratio of 3:1 to 5:1 and in the cross direction at a draw ratio of 3:1 to 8:1.

In some embodiments, the ratio of the draw ratio in the machine direction to the draw ratio in the cross direction is from 1:1 to 1:2.5. In some embodiments, the ratio of the draw ratio in the machine direction to the draw ratio in the cross direction is from 1:1.5 to 1:2.0.

In some embodiments, the biaxially oriented polyethylene film has an overall draw ratio (draw ratio in machine direction X draw ratio in cross direction) of 8 to 54. The biaxially oriented polyethylene film, in some embodiments, has an overall draw ratio (draw ratio in machine direction X draw ratio in cross direction) of 9 to 40.

After orientation, the biaxially oriented film has a thickness of 10 to 60 microns in some embodiments. In some embodiments, the biaxially oriented film has a thickness of 20 to 50 microns.

In some embodiments, depending for example on the end use application, the biaxially oriented polyethylene film can be corona treated, plasma treated, or printed using techniques known to those of skill in the art.

Following biaxial orientation, the biaxially oriented polyethylene films are then provided with a metal layer on the outer layer comprising the linear low density polyethylene described above.

Metal Layer

The metal layer is applied to the outer layer of the biaxially oriented polyethylene film using vacuum metallization. Vacuum metallization is a well-known technique for depositing metals in which a metal source is evaporated in a vacuum environment, and the metal vapor condenses on the surface of the film to form a thin layer as the film passes through the vacuum chamber.

The metals that can be deposited on the outer layer of the biaxially oriented polyethylene film include Al, Zn, Au, Ag, Cu, Ni, Cr, Ge, Se, Ti, Sn, or oxides thereof. In some embodiments, the metal layer is formed from aluminum or aluminum oxide ($Al_2O_3$).

With the metal layer on the biaxially oriented polyethylene film, the multilayer structure can be characterized by its optical density when measured as described in the TEST METHODS section below. In some embodiments, the multilayer structure has an optical density of 1.0 to 3.0. The multilayer structure has an optical density of 2.0 to 2.8 in some embodiments.

The metal layer advantageously provides a good barrier to oxygen and water vapor.

Multilayer Structures

Multilayer structures of the present invention, in some embodiments, comprise a biaxially oriented polyethylene film and a metal layer deposited thereon (as described above). The combination of biaxially oriented polyethylene film with the metal layer deposited on the specified outer surface can provide a synergistic combination of both mechanical and barrier properties.

For example, in some embodiments, the multilayer structure comprising a biaxially oriented polyethylene film and metal layer deposited thereon (as described above) has a 2% secant modulus of at least 300 MPa in the machine direction when measured according to ASTM D882, and wherein the multilayer structure has an oxygen gas transmission rate of 350 cc/[m²-day] or less when measured according to ASTM D3985-05. In some further embodiments, the multilayer structure multilayer structure has a dart impact of at least grams/micron when measured according to ASTM D1709 (Method A).

The multilayer structures, in some embodiments, can also have acceptable stiffness, good optical properties, and low temperature sealing performance.

Articles

Multilayer structures of the present invention can be used to form articles such as packages. Such articles can be formed from any of the multilayer structures described herein.

Examples of packages that can be formed from multilayer structures of the present invention can include flexible packages, pouches, stand-up pouches, and pre-made packages or pouches. In some embodiments, multilayer films of the present invention can be used for food packages. Examples of food that can be included in such packages include meats, cheeses, cereal, nuts, juices, sauces, and others. Such packages can be formed using techniques known to those of skill in the art based on the teachings herein and based on the particular use for the package (e.g., type of food, amount of food).

TEST METHODS

Unless otherwise indicated herein, the following analytical methods are used in describing aspects of the present invention:

*Density*

Samples for density measurement are prepared according to ASTM D 1928. Polymer samples are pressed at 190° C and 30,000 psi (207 MPa) for three minutes, and then at 21° C and 207 MPa for one minute. Measurements are made within one hour of sample pressing using ASTM D792, Method B.

*Melt Index*

Melt indices $I_2$ (or 12) and $I_{10}$ (or I10) are measured in accordance with ASTM D-1238 at 190° C and at 2.16 kg and 10 kg load, respectively. Their values are reported in g/10 min. "Melt flow rate" is used for polypropylene based resins and determined according to ASTM D1238 (230° C at 2.16 kg).

*Melt Flow Rate*

Melt flow rates are measured in accordance with ASTM D-1238 or ISO 1133 (230°C; 2.16 kg).

*Crystallization Elution Fractionation (CEF)*

Crystallization Elution Fractionation (CEF) is described by Monrabal et al, Macromol. Symp. 257, 71-79 (2007). The instrument is equipped with an IR-4 detector (such as that sold commercially from PolymerChar, Spain) and a two angle light scattering detector Model 2040 (such as those sold commercially from Precision Detectors). The IR-4 detector operates in the compositional mode with two filters: C006 and B057. A 10 micron guard column of 50X4.6 mm (such as that sold commercially from PolymerLabs) is installed before the IR-4 detector in the detector oven. Ortho-dichlorobenzene (ODCB, 99% anhydrous grade) and 2,5-di-tert-butyl-4-methylphenol (BHT) (such as commercially available from Sigma-Aldrich) are obtained. Silica gel 40 (particle size 0.2~0.5 mm) (such as commercially available from EMD Chemicals) is also obtained. The silica gel is dried in a vacuum oven at 160°C for about two hours before use. Eight hundred milligrams of BHT and five grams of silica gel are added to two liters of ODCB. ODCB containing BHT and silica gel is now referred to as "ODCB." ODBC is sparged with dried nitrogen ($N_2$) for one hour before use. Dried nitrogen is obtained by passing nitrogen at <90 psig over $CaCO_3$ and 5Å molecular sieves. Sample preparation is done with an autosampler at 4 mg/ml under shaking at 160°C for 2 hours. The injection volume is 300 $\mu$1. The temperature profile of CEF is: crystallization at 3°C/min from 110°C to 30°C, thermal equilibrium at 30°C for 5 minutes (including Soluble Fraction Elution Time being set as 2 minutes), and elution at 3°C/min from 30°C to 140°C. The flow rate during crystallization is 0.052 ml/min. The flow rate during elution is 0.50 ml/min. The data are collected at one data point/second.

The CEF column is packed with glass beads at 125 $\mu$m$\pm$ 6% (such as those commercially available from MO-SCI Specialty Products) with 1/8 inch stainless tubing according to US 2011/0015346 A1. The internal liquid volume of the CEF column is between 2.1 and 2.3 mL. Temperature calibration is performed by using a mixture of NIST Standard Reference Material Linear polyethylene 1475a (1.0 mg/ml) and Eicosane (2 mg/ml) in ODCB. The calibration consists of four steps: (1) Calculating the delay volume defined as the temperature offset between the measured peak elution temperature of Eicosane minus 30.00°C; (2) Subtracting the temperature offset of the elution temperature from the CEF raw temperature data. It is noted that this temperature offset is a function of experimental conditions, such as elution temperature, elution flow rate, (3)Creating a linear calibration line transforming the elution temperature across a range of 30.00°C and 140.00°C such that NIST linear polyethylene 1475a has a peak temperature at 101.00°C, and Eicosane has a peak temperature of 30.00°C, (4) For the soluble fraction measured isothermally at 30°C, the elution temperature is extrapolated linearly by using the elution heating rate of 3°C/min. The reported elution peak temperatures are obtained such that the observed comonomer content calibration curve agrees with those previously reported in US 8,372,931.

A linear baseline is calculated by selecting two data points: one before the polymer elutes, usually at temperature of 26°C, and another one after the polymer elutes, usually at 118°C. For each data point, the detector signal is subtracted from the baseline before integration.

Molecular weight of high density fraction $(MW_{HDF>95})$ and high density fraction index $(I_{HDF>95})$

The polymer molecular weight can be determined directly from LS (light scattering at 90 degree angle, Precision Detectors) and the concentration detector (IR-4, Polymer Char) according to the Rayleigh-Gans-Debys approximation (A. M. Striegel and W. W. Yau, Modern Size-Exclusion Liquid Chromatography, 2nd Edition, Page 242 and Page 263, 2009) by assuming a form factor of 1 and all the virial coefficients equal to zero. Baselines are subtracted from the LS (90 degree) and IR-4 (measurement channel) chromatograms. For the whole resin, integration windows are set to integrate all the chromatograms in the elution temperature (temperature calibration is specified above) ranging from 25.5 to 118 °C. The high density fraction is defined as the fraction that has an elution temperature higher than 95.0 °C in CEF. Measuring the $MW_{HDF>95}$ and $I_{HDF>95}$ includes the following steps:

(1) Measuring the interdetector offset. The offset is defined as the geometric volume offset between LS detector with respect to the IR-4 detector. It is calculated as the difference in elution volume (mL) of the polymer peak between the IR-4 and LS chromatograms. It is converted to the temperature offset by using the elution thermal rate and elution flow rate. A high density polyethylene (with no comonomer, melting index $I_2$ of 1.0, polydispersity or molecular weight distribution $M_w/M_n$ 2.6 by conventional gel permeation chromatography) is used. The same experimental conditions as the CEF method above are used except for the following parameters: crystallization at 10°C/min from 140°C to 137°C, thermal equilibrium at 137°C for 1 minute as the Soluble Fraction Elution Time, and elution at 1°C/min from 137°C to 142°C. The flow rate during crystallization is 0.10 ml/min. The flow rate during elution is 0.80 ml/min. The sample concentration is 1.0 mg/ml.
(2) Each data point in the LS chromatogram is shifted to correct for the interdetector offset before integration.
(3) Molecular weight at each retention temperature is calculated as the baseline subtracted LS signal/the baseline subtracted IR4 signal/MW constant (K).
(4) The baseline subtracted LS and IR-4 chromatograms are integrated in the elution temperature range of 95.0 to 118.0°C.
(5) The Molecular weight of the high density fraction $(MW_{HDF>95})$ is calculated according to

$$MW_{HDF>95} = \int_{95}^{118} Mw \cdot C \cdot dT \Big/ \int_{95}^{118} C \cdot dT$$

where $Mw$ is the molecular weight of the polymer fraction at the elution temperature $T$ and C is the weight fraction of the polymer fraction at the elution temperature $T$ in the CEF, and

$$\int_{25}^{118} C \cdot dT = 100\%$$

(6) High density fraction index $(I_{HDF>95})$ is calculated as

$$I_{HDF>95} = \int_{95}^{118} Mw \cdot C \cdot dT$$

where $Mw$ in is the molecular weight of the polymer fraction at the elution temperature $T$ in the CEF.

The MW constant (K) of CEF is calculated by using NIST polyethylene 1484a analyzed with the same conditions as for measuring interdetector offset. The MW constant (K) is calculated as "(the total integrated area of LS) of NIST PE 1484a / (the total integrated area) of IR-4 measurement channel of NIST PE 1484a / 122,000".

The white noise level of the LS detector (90 degree) is calculated from the LS chromatogram prior to the polymer eluting. The LS chromatogram is first corrected for the baseline correction to obtain the baseline subtracted signal. The white noise of the LS is calculated as the standard deviation of the baseline subtracted LS signal by using at least 100 data points prior to the polymer eluting. Typical white noise for LS is 0.20 to 0.35 mV while the whole polymer has a baseline subtracted peak height typically around 170 mV for the high density polyethylene with no comonomer, $I_2$ of 1.0, polydispersity $M_w/M_n$ 2.6 used in the interdetector offset measurements. Care should be maintained to provide a signal to noise ratio (the peak height of the whole polymer to the white noise) of at least 500 for the high density polyethylene.

*Heat Seal Strength*

A hot tack tester (Model 4000 from J&B Corp.) is used in "seal only" mode without pulling. To form the heat seal, the seal parameters are as follows: width of sample strip=1 inch; seal time=0.5s; seal pressure=0.275MPa. The sealed sample strips are aged 24 hours, under controlled environment ($23\pm2°C$, $55\pm5\%$ relative humidity). Thereafter, the seal strength is tested on a tensile machine (Type 5965 from INSTRON Corp.) with a pulling speed of 500 mm/min. The maximum load is recorded as sealing strength.

*Ultimate Tensile Stress and Strain, Young's Modulus, and 2% Secant Modulus*

The ultimate tensile stress and strain, Young's modulus, and 2% secant modulus are measured in accordance with ASTM D-882.

*Puncture Strength*

The puncture strength of the film was measured on a tensile tester (Model 5965 from Instron) using the compression method. A film sample is clamped in a holder to provide a sample area having a diameter of 102 mm. Then, a puncture probe having a 12 mm diameter round profile moves vertically downward at a speed of 250 mm/minute. The test is stopped when the puncture probe passes completely though the film sample. The maximum force is recorded based on a measurement from mechanical testing software (Bluehill3).

*Dart Impact Strength*

The dart impact strength is measured in accordance with ASTM D-1709 (Method A).

*Oxygen Transmission Rate*

The oxygen transmission rate is measured in accordance with ASTM D-3985 using a MOCON OX-TRAN Model 2/21 measurement device at a temperature of 23°C at a relative humidity of 0% using purified oxygen on a 5 $cm^2$ film sample.

*Water Vapor Transmission Rate*

The water vapor transmission rate is measured in accordance with ASTM F-1249 using a MOCON PERMA-TRAN-W 3/33 measurement device at a temperature of 37.8°C at a relative humidity of 100% using water vapor on a 5 $cm^2$ film sample.

*Gloss of Metallized Surface*

The gloss of the metal layer is measured using a spectrophotometer (Konica Minolta Model CM-2600d). The results are recorded by reading the data displayed on the device in "L" mode directly.

*Optical Density*

The optical density of a metallized film (e.g., a multilayer structure comprising a polyethylene film with a metal layer deposited on it) is measured using an optical density meter (Model No. LS177 from Shenzhen Linshang Technology).
Some embodiments of the invention will now be described in detail in the following Examples.

**Examples**

A number of multilayer structures are prepared for evaluation are prepared as shown in Table 1:

**Table 1**

| | Substrate | Thickness of Substrate (microns) | Optical Density |
|---|---|---|---|
| Inventive Structure 1 | BOPE | 50 | 2.2 |
| Comparative Structure A | Blown PE | 50 | 2.2 |
| Comparative Structure B | Cast PP | 25 | 2.5 |

Comparative Structure A is a vacuum metallized polyethylene film formed as a blown film that is not subjected to a semi-molten orientation step. The metallized polyethylene film has an optical density of 2.2. Optical densities are measured in these Examples using the method described in the TEST METHODS section above.

Comparative Structure B is a vacuum metallized polypropylene film (product VMC104NO commercially available from Novel Huangshan Packaging Co., Ltd.) with an optical density of 2.5.

Regarding Inventive Structure 1, the BOPE film used in Inventive Structure 1 is model Lightweight PE film (DL) having a thickness of 50 microns (after orientation), commercially available from Guangdong Decro Film New Materials CO. Ltd. The film is a biaxially oriented, 2 layer film having an outer layer and a sealant layer.

The outer layer is a polyethylene composition from The Dow Chemical Company comprising at least two linear low density polyethylenes from the The Dow Chemical Company. The polyethylene composition has a density of 0.925 g/cm$^3$ and a melt index ($I_2$) of 1.7 g/10 minutes, and is characterized by having an $MW_{HDF>95}$ of 137.9 kg/mol and an $I_{HDF>95}$ of 67.4 kg/mol when measured as described in the TEST METHODS above.

The sealant layer is formed from a LLDPE resin with density lower than 0.925g/cm3 with 5$\mu$m thickness.

A layer of aluminum is deposited on the outer layer of the BOPE film by vacuum metallization using an industrial metallizer (Leybold PRO-M2500). The optical density of Inventive Structure 1 is 2.2.

The oxygen transmission rate (OTR) and water vapor transmission rate (WVTR) of the structures are measured to evaluate their effectiveness as barrier films. The glosses of the metallized surface are also measured. The results are shown in Table 2:

**Table 2**

| | Substrate | OTR (cc/m$^2$-day) | WVTR (g/m$^2$-day) | Gloss |
|---|---|---|---|---|
| Inventive Structure 1 | BOPE | 221 | 7.31 | 96.2 |
| Comparative Structure A | Blown PE | 298 | 6.45 | 95.1 |
| Comparative Structure B | Cast PP | 153 | 1.28 | 96.9 |

In comparison with Comparative Structure A, the barrier properties of Inventive Structure 1 are better and comparable in terms of OTR and WVTR, respectively, even though neither performed as well as Comparative Structure B. Meanwhile, the metallized surface of Inventive Structure 1 is much glossier than Comparative Structure A, which can afford more attractive appearance to packages.

Various mechanical properties of Inventive Structure 1 and Comparative Structures A and B are also measured. The results are shown in Table 3, with MD referring to properties in the machine direction and TD referring to properties in the transverse or cross direction.

**Table 3**

| | Inventive Structure 1 | Comparative Structure A | Comparative Structure B |
|---|---|---|---|
| Ultimate Tensile Stress-MD (MPa) | 70.6 | 34.9 | 66.0 |
| Ultimate Tensile Stress-TD (MPa) | 130.6 | 23.9 | 36.4 |
| Ultimate Tensile Strain-MD (%) | 371.5 | 604.8 | 655.5 |

(continued)

| | Inventive Structure 1 | Comparative Structure A | Comparative Structure B |
|---|---|---|---|
| Ultimate Tensile Strain-TD (%) | 59.9 | 994.4 | 920.8 |
| 2% Secant Modulus -MD (MPa) | 409.3 | 272.6 | 844.8 |
| 2% Secant Modulus -TD (MPa) | 820.4 | 314.5 | 850.9 |
| Young's Modulus -MD (MPa) | 530.0 | 339.7 | 898.2 |
| Young's Modulus -TD (MPa) | 972.4 | 302.2 | 889.3 |
| Puncture Strength (Force at Max, N) | 163.8 | 32.9 | 29.4 |
| Dart Impact (Method A) (g) | 729.2 | <135.24 | <135.24 |

As shown in Table 3, Inventive Structure 1 shows excellent film strength in both directions, decent stiffness in the cross direction, and outstanding toughness as shown by puncture strength and dart resistance. These results show that Inventive Structure 1 not only works well as a barrier but also can also significantly improve the abuse performance of packages formed from it and similar structures.

The heat seal strengths of Inventive Structure 1 and Comparative Structure B are also measured. The results are shown in Table 4.

**Table 4**

| | Heat Seal Strength of Inventive Structure 1 (N/25 mm) | Heat Seal Strength of Comparative Structure B (N/25 mm) |
|---|---|---|
| 90°C | 6.3 | Not Measured |
| 100°C | 23.6 | Not Measured |
| 110°C | 27.8 | 5.3 |
| 120°C | 25.7 | 22.1 |
| 130°C | 35.8 | 22.4 |
| 140°C | 33.4 | 24.1 |
| 150°C | 34.5 | 26.3 |

The heat seal initiation temperature is an important property and can be considered for some applications to be the lowest temperature at which a structure exhibits a seal strength of 25 N/25 mm. For the above data, Inventive Structure 1 exhibits a heat seal initiation temperature that is ~20° C lower than the heat seal initiation temperature of Comparative Film B. Thus, as a potential replacement for metallized polypropylene films, Inventive Structure 1 can be helpful in increasing the packaging speed and reducing the leakage rate.

In summary, Inventive Structure 1 possesses good barrier properties, outstanding mechanical performance as well as low temperature sealing strength. This synergy of relevant functions demonstrates excellent potential value for multiple applications including, for example, flexible packages.

**Claims**

1. A multilayer structure comprising:

(a) a biaxially oriented polyethylene film comprising an outer layer that comprises a first polyethylene composition comprising at least two linear low density polyethylenes, wherein the first polyethylene composition has a density of 0.910 to 0.940 g/cm$^3$, where density is determined as set out in the description, an $MW_{HDF>95}$ greater than 135 kg/mol and an $I_{HDF>95}$ greater than 42 kg/mol (measured with Crystallization Elution Fractionation CEF) wherein the film has a thickness of 10 to 60 $\mu$m (microns) after orientation; and

(b) a metal layer comprising a metal deposited on the outer layer, wherein the metal comprises Al, Zn, Au, Ag, Cu, Ni, Cr, Ge, Se, Ti, Sn, or oxides thereof, and wherein the multilayer structure has an optical density of 1.0 to 3.6, wherein optical density is measured using an optical density meter,

wherein the multilayer structure has a 2% secant modulus of at least 300 MPa in the machine direction when measured according to ASTM D882, and wherein the multilayer structure has an oxygen gas transmission rate of 350 cc/[m$^2$-day] or less when measured according to ASTM D3985-05.

2. The multilayer structure of claim 1, wherein the biaxially oriented polyethylene film is oriented in the machine direction at a draw ratio from 2:1 to 6:1 and in the cross direction at a draw ratio from 2:1 to 9:1.

3. The multilayer structure of claim 1 or claim 2, wherein the biaxially oriented polyethylene film has an overall draw ratio (draw ratio in machine direction X draw ratio in cross direction) of 8 to 54.

4. The multilayer structure of any of the preceding claims, wherein the ratio of the draw ratio in the machine direction to the draw ratio in the cross direction is from 1:1 to 1:2.5.

5. The multilayer structure of any of the preceding claims, wherein the outer layer of the biaxially oriented polyethylene film comprises at least 50 weight percent of the first polyethylene composition based on the weight of the outer layer, and wherein the outer layer further comprises at least one of a high density polyethylene, a low density polyethylene, an ultra low density polyethylene, a polyethylene plastomer, a polyethylene elastomer, an ethylene vinyl acetate copolymer, an ethylene ethyl acrylate copolymer and any polymer comprising at least 50% ethylene monomer.

6. The multilayer structure of any of the preceding claims, wherein the biaxially oriented polyethylene film is a multilayer film.

7. The multilayer structure of any of the preceding claims, wherein the biaxially oriented polyethylene film further comprises a sealant layer.

8. The multilayer structure of any of claims 1 to 5, wherein the biaxially oriented polyethylene film is a monolayer film.

9. The multilayer structure of any of the preceding claims, wherein the multilayer structure has a dart impact of at least 10 grams/micron when measured according to ASTM D1709 (Method A).

10. An article comprising the multilayer structure of any of the preceding claims.

11. A process for manufacturing a multilayer structure comprising:

(a) forming a polyethylene film having an outer layer that comprises a first polyethylene composition comprising at least two linear low density polyethylenes, wherein the first polyethylene composition has a density of 0.910 to 0.940 g/cm$^3$, where density is determined as set out in the description, an $MW_{HDF>95}$ greater than 135 kg/mol and an $I_{HDF>95}$ greater than 42 kg/mol;

(b) biaxially orienting the polyethylene film from step (a) by orienting the film in the machine direction at a draw ratio from 2:1 to 6:1 and in the cross direction at a draw ratio from 2:1 to 9:1, wherein the oriented polyethylene film has a thickness of 10 to 60 microns after orientation; and

(c) vacuum depositing a metal layer on the outer layer of the polyethylene film, wherein the metal comprises Al, Zn, Au, Ag, Cu, Ni, Cr, Ge, Se, Ti, Sn, or oxides thereof, and wherein the multilayer structure has an optical density of 1.0 to 3.6, wherein optical density is measured using an optical density meter.

12. The process of claim 11, wherein the draw ratio in the machine direction is 3:1 to 5:1 and the draw ratio in the cross direction is 3:1 to 8:1.

13. The process of claim 11 or claim 12, wherein the ratio of the draw ratio in the machine direction to the draw ratio in the cross direction is from 1:1 to 1:2.5.

**Patentansprüche**

1. Eine Mehrschichtstruktur, die Folgendes beinhaltet:

   (a) eine biaxial orientierte Polyethylenfolie, beinhaltend eine äußere Schicht, die eine erste Polyethylenzusammensetzung, beinhaltend mindestens zwei lineare Polyethylene niedriger Dichte, beinhaltet, wobei die erste Polyethylenzusammensetzung eine Dichte von 0,910 bis 0,940 g/cm$^3$, wobei die Dichte wie in der Beschreibung angegeben bestimmt wird, ein MW$_{HDF>95}$ von mehr als 135 kg/mol und einen I$_{HDF>95}$ von mehr als 42 kg/mol (gemessen mit Kristallisationselutionsfraktionierung CEF), aufweist,
   wobei die Folie nach der Orientierung eine Dicke von 10 bis 60 μm (Mikrometer) aufweist; und
   (b) eine Metallschicht, beinhaltend ein auf der äußeren Schicht abgeschiedenes Metall, wobei das Metall Al, Zn, Au, Ag, Cu, Ni, Cr, Ge, Se, Ti, Sn oder Oxide davon beinhaltet, und wobei die Mehrschichtstruktur eine optische Dichte von 1,0 bis 3,6 aufweist, wobei die optische Dichte unter Verwendung eines Messgeräts für optische Dichte gemessen wird,
   wobei die Mehrschichtstruktur einen 2-%-Sekantenmodul von mindestens 300 MPa in Maschinenrichtung aufweist, wenn er gemäß ASTM D882 gemessen wird, und wobei die Mehrschichtstruktur eine Sauerstoffgasübertragungsrate von 350 cm$^3$/[m$^2$-Tag] oder weniger aufweist, wenn sie gemäß ASTM D3985-05 gemessen wird.

2. Mehrschichtstruktur gemäß Anspruch 1, wobei die biaxial orientierte Polyethylenfolie in Maschinenrichtung mit einem Ziehverhältnis von 2 : 1 bis 6 : 1 und in Querrichtung mit einem Ziehverhältnis von 2 : 1 bis 9 : 1 orientiert ist.

3. Mehrschichtstruktur gemäß Anspruch 1 oder Anspruch 2, wobei die biaxial orientierte Polyethylenfolie ein gesamtes Ziehverhältnis (Ziehverhältnis in Maschinenrichtung X Ziehverhältnis in Querrichtung) von 8 bis 54 aufweist.

4. Mehrschichtstruktur gemäß einem der vorhergehenden Ansprüche, wobei das Verhältnis des Ziehverhältnisses in Maschinenrichtung zu dem Ziehverhältnis in Querrichtung 1 : 1 bis 1 : 2,5 beträgt.

5. Mehrschichtstruktur gemäß einem der vorhergehenden Ansprüche, wobei die äußere Schicht der biaxial orientierten Polyethylenfolie zu mindestens 50 Gewichtsprozent, bezogen auf das Gewicht der äußeren Schicht, die erste Polyethylenzusammensetzung beinhaltet und wobei die äußere Schicht ferner mindestens eines von einem Polyethylen hoher Dichte, einem Polyethylen niedriger Dichte, einem Polyethylen ultraniedriger Dichte, einem Polyethylenplastomer, einem Polyethylenelastomer, einem Ethylenvinylacetatcopolymer, einem Ethylenethylacrylatcopolymer und einem beliebigen Polymer, das zu mindestens 50 % Ethylenmonomer beinhaltet, beinhaltet.

6. Mehrschichtstruktur gemäß einem der vorhergehenden Ansprüche, wobei die biaxial orientierte Polyethylenfolie eine Mehrschichtfolie ist.

7. Mehrschichtstruktur gemäß einem der vorhergehenden Ansprüche, wobei die biaxial orientierte Polyethylenfolie ferner eine Siegelschicht beinhaltet.

8. Mehrschichtstruktur gemäß einem der Ansprüche 1 bis 5, wobei die biaxial orientierte Polyethylenfolie eine Monoschichtfolie ist.

9. Mehrschichtstruktur gemäß einem der vorhergehenden Ansprüche, wobei die Mehrschichtstruktur eine Durchstoßfestigkeit von mindestens 10 Gramm/Mikrometer aufweist, wenn sie gemäß ASTM D1709 (Methode A) gemessen wird.

10. Ein Artikel, der die Mehrschichtstruktur gemäß einem der vorhergehenden Ansprüche beinhaltet.

11. Ein Verfahren zum Herstellen einer Mehrschichtstruktur, das Folgendes beinhaltet:

    (a) Bilden einer Polyethylenfolie, die eine äußere Schicht aufweist, die eine erste Polyethylenzusammensetzung, beinhaltend mindestens zwei lineare Polyethylene niedriger Dichte, beinhaltet, wobei die erste Polyethylenzusammensetzung eine Dichte von 0,910 bis 0,940 g/cm$^3$, wobei die Dichte wie in der Beschreibung angegeben bestimmt wird, ein MW$_{HDF>95}$ von mehr als 135 kg/mol und einen I$_{HDF>95}$ von mehr als 42 kg/mol, aufweist;
    (b) biaxiales Orientieren der Polyethylenfolie aus Schritt (a) durch Orientieren der Folie in Maschinenrichtung bei einem Ziehverhältnis von 2 : 1 bis 6 : 1 und in Querrichtung bei einem Ziehverhältnis von 2:1 bis 9 : 1, wobei die orientierte Polyethylenfolie nach der Orientierung eine Dicke von 10 bis 60 Mikrometer aufweist; und

(c) Vakuumabscheiden einer Metallschicht auf der äußeren Schicht der Polyethylenfolie, wobei das Metall Al, Zn, Au, Ag, Cu, Ni, Cr, Ge, Se, Ti, Sn oder Oxide davon beinhaltet, und wobei die Mehrschichtstruktur eine optische Dichte von 1,0 bis 3,6 aufweist, wobei die optische Dichte unter Verwendung eines Messgeräts für optische Dichte gemessen wird.

12. Verfahren gemäß Anspruch 11, wobei das Ziehverhältnis in Maschinenrichtung 3 : 1 bis 5 : 1 beträgt und das Ziehverhältnis in Querrichtung 3 : 1 bis 8 : 1 beträgt.

13. Verfahren gemäß Anspruch 11 oder Anspruch 12, wobei das Verhältnis des Ziehverhältnisses in Maschinenrichtung zu dem Ziehverhältnis in Querrichtung 1 : 1 bis 1 : 2,5 beträgt.

**Revendications**

1. Une structure multicouche comprenant :

(a) un film de polyéthylène orienté biaxialement comprenant une couche extérieure qui comprend une première composition de polyéthylène comprenant au moins deux polyéthylènes basse densité linéaires, dans laquelle la première composition de polyéthylène a une masse volumique de 0,910 à 0,940 g/cm$^3$, où la masse volumique est déterminée tel qu'exposé dans la description, une $MW_{HDF>95}$ supérieure à 135 kg/mole et un $I_{HDF>95}$ supérieur à 42 kg/mole (mesurés avec un fractionnement par cristallisation et élution CEF) dans laquelle le film a une épaisseur de 10 à 60 $\mu$m (micromètres) après l'orientation ; et
(b) une couche de métal comprenant un métal déposé sur la couche extérieure, dans laquelle le métal comprend de l'Al, du Zn, de l'Au, de l'Ag, du Cu, du Ni, du Cr, du Ge, du Se, du Ti, du Sn, ou des oxydes de ceux-ci, et la structure multicouche ayant une densité optique de 1,0 à 3,6, dans laquelle la densité optique est mesurée à l'aide d'un densimètre optique,
la structure multicouche ayant un module sécant à 2 % d'au moins 300 MPa dans le sens machine lorsqu'il est mesuré selon l'ASTM D882, et la structure multicouche ayant un taux de transmission de gaz oxygène de 350 cm$^3$/[m$^2$-jour] ou moins lorsqu'il est mesuré selon l'ASTM D3985-05.

2. La structure multicouche de la revendication 1, dans laquelle le film de polyéthylène orienté biaxialement est orienté dans le sens machine à un rapport d'étirage allant de 2/1 à 6/1 et dans le sens travers à un rapport d'étirage allant de 2/1 à 9/1.

3. La structure multicouche de la revendication 1 ou de la revendication 2, dans laquelle le film de polyéthylène orienté biaxialement a un rapport d'étirage global (rapport d'étirage dans le sens machine X rapport d'étirage dans le sens travers) de 8 à 54.

4. La structure multicouche de n'importe lesquelles des revendications précédentes, dans laquelle le rapport du rapport d'étirage dans le sens machine au rapport d'étirage dans le sens travers va de 1/1 à 1/2,5.

5. La structure multicouche de n'importe lesquelles des revendications précédentes, dans laquelle la couche extérieure du film de polyéthylène orienté biaxialement comprend au moins 50 pour cent en poids de la première composition de polyéthylène rapporté au poids de la couche extérieure, et dans laquelle la couche extérieure comprend en outre au moins soit un polyéthylène haute densité, soit un polyéthylène basse densité, soit un polyéthylène ultra basse densité, soit un plastomère de polyéthylène, soit un élastomère de polyéthylène, soit un copolymère d'éthylène-acétate de vinyle, soit un copolymère d'éthylène-acrylate d'éthyle et soit n'importe quel polymère comprenant au moins 50 % de monomère d'éthylène.

6. La structure multicouche de n'importe lesquelles des revendications précédentes, dans laquelle le film de polyéthylène orienté biaxialement est un film multicouche.

7. La structure multicouche de n'importe lesquelles des revendications précédentes, dans laquelle le film de polyéthylène orienté biaxialement comprend en outre une couche de matériau d'étanchéité.

8. La structure multicouche de n'importe lesquelles des revendications 1 à 5, dans laquelle le film de polyéthylène orienté biaxialement est un film monocouche.

9. La structure multicouche de n'importe lesquelles des revendications précédentes, la structure multicouche ayant une résistance au choc d'un projectile d'au moins 10 grammes/micromètre lorsqu'elle est mesurée selon l'ASTM D1709 (Méthode A).

10. Un article comprenant la structure multicouche de n'importe lesquelles des revendications précédentes.

11. Un procédé de fabrication d'une structure multicouche comprenant :

(a) le fait de former un film de polyéthylène ayant une couche extérieure qui comprend une première composition de polyéthylène comprenant au moins deux polyéthylènes basse densité linéaires, dans lequel la première composition de polyéthylène a une masse volumique de 0,910 à 0,940 g/cm$^3$, où la masse volumique est déterminée tel qu'exposé dans la description, une $MW_{HDF>95}$ supérieure à 135 kg/mole et un $I_{HDF>95}$ supérieur à 42 kg/mole ;
(b) le fait d'orienter biaxialement le film de polyéthylène de l'étape (a) en orientant le film dans le sens machine à un rapport d'étirage allant de 2/1 à 6/1 et dans le sens travers à un rapport d'étirage allant de 2/1 à 9/1, dans lequel le film de polyéthylène orienté a une épaisseur de 10 à 60 micromètres après l'orientation ; et
(c) le fait de déposer sous vide une couche de métal sur la couche extérieure du film de polyéthylène, dans lequel le métal comprend de l'Al, du Zn, de l'Au, de l'Ag, du Cu, du Ni, du Cr, du Ge, du Se, du Ti, du Sn, ou des oxydes de ceux-ci, et dans lequel la structure multicouche a une densité optique de 1,0 à 3,6, dans lequel la densité optique est mesurée à l'aide d'un densimètre optique.

12. Le procédé de la revendication 11, dans lequel le rapport d'étirage dans le sens machine est de 3/1 à 5/1 et le rapport d'étirage dans le sens travers est de 3/1 à 8/1.

13. Le procédé de la revendication 11 ou de la revendication 12, dans lequel le rapport du rapport d'étirage dans le sens machine au rapport d'étirage dans le sens travers va de 1/1 à 1/2,5.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0040407 A
- US 4599392 A
- US 5272236 A
- US 5278272 A
- US 5582923 A
- US 5733155 A
- US 3645992 A
- US 4076698 A
- US 3914342 A
- US 5854045 A
- US 20110015346 A1
- US 8372931 B

**Non-patent literature cited in the description**

- **MONRABAL et al.** *Macromol. Symp.,* 2007, vol. 257, 71-79
- **A. M. STRIEGEL ; W. W. YAU.** *Modern Size-Exclusion Liquid Chromatography,* 2009, 242, , 263